# EUROPEAN PATENT SPECIFICATION

(11) **EP 2 767 885 B1**
(45) Date of publication and mention of the grant of the patent: **31.08.2016**
(21) Application number: 14155352.9
(22) Date of filing: 17.02.2014
(51) Int. Cl.: G06F 1/20, H05K 7/20

(54) **Hand-held electronic device**
Tragbare elektronische Vorrichtung
Dispositif électronique portable

(30) Priority: 18.02.2013 TW 102105585
(43) Date of publication of application: 20.08.2014
(73) Proprietor: Sunonwealth Electric Machine Industry Co., Ltd., Kaohsiung, Taiwan R.O.C. (TW)
(72) Inventor: Horng, Alex, Kaohsiung, Taiwan, R.O.C. (TW)
(74) Representative: Köhler, Walter

(56) References cited:
- US-A1- 2003 184 967

## Description

### BACKGROUND OF THE INVENTION

### 1. Field of the Invention

The present invention relates to a hand-held electronic device and, more particularly, to a hand-held electronic device capable of reducing the temperature of its electronic component.

### 2. Description of the Related Art

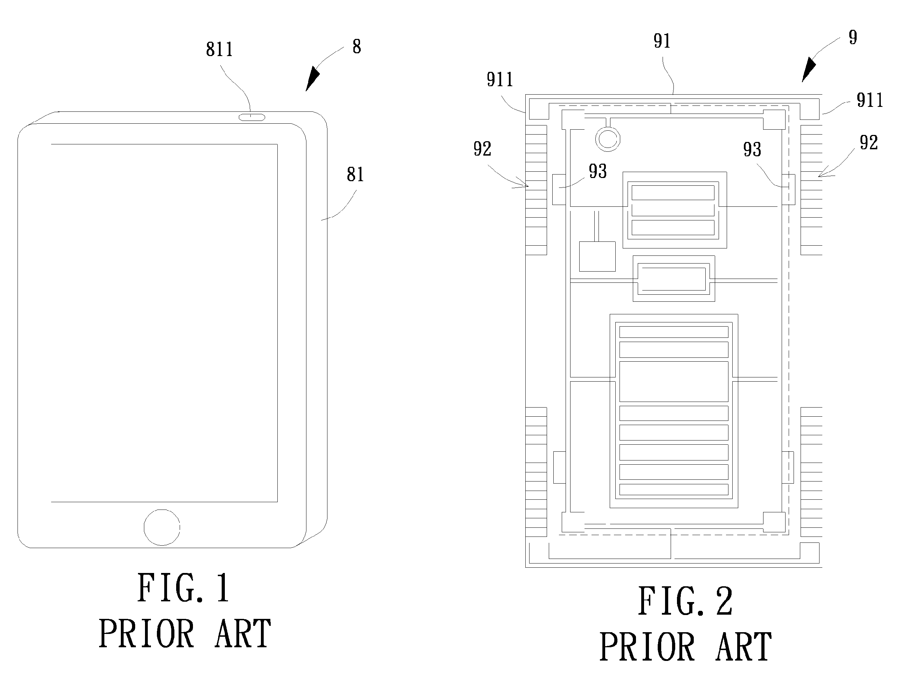

FIG. 1 shows a conventional hand-held electronic device 8 including an enclosure 81 defining a compartment in which a processor and a fan are received. The enclosure 81 includes a peripheral wall having a receiving port 811. The fan can be operated to make air flow through the receiving port 811 for exchanging the air in the compartment with the ambient air surrounding the enclosure 81, thereby cooling the processor. An example of such a hand-held electronic device 8 is disclosed in U.S. Patent No. 8,477,490 B2.

FIG. 2 shows a conventional cell phone 9 including a casing 91 receiving electronic elements. The casing 91 includes two parallel lateral sides 911 each having a plurality of vents 92. A fan 93 is mounted in a location adjacent to each vent 92 and can be operated to cool the electronic elements. An example of such a cell phone 9 is disclosed in Taiwan Patent Publication No. 201238317.

The receiving port 811 of the hand-held electronic device 8 and the vents 92 of the cell phone 9 are arranged on the peripheral walls of the enclosure 81 and the casing 91, respectively. However, in use, the user must hold the enclosure 81 or casing 91 with a hand such that the hand of the user may directly cover the receiving port 811 or vents 92, adversely affecting the air intake or outtake function of the receiving port 811 or vents 92. Thus, the cooling effect is reduced.

US 2003/184967 A1 discloses an electronic device according to the preamble of claim 1.

Thus, a need exists for a novel hand-held electronic device with improved cooling effect.

### SUMMARY OF THE INVENTION

An objective of the present invention is to provide a hand-held electronic device preventing the hand of the user from covering the vents, avoiding adverse effects on the air intake or outtake and achieving the expected cooling effect.

The present invention fulfills the above objective by providing a hand-held electronic device including a casing having a first face and a second face opposite to the first face. The casing includes an interior intermediate the first face and the second face of the casing. A first cover includes a thickness forming an annular periphery and abuts the first face of the casing. A joining area between the annular periphery of the first cover and the first face of the casing includes a junction section having at least one vent in communication with the interior of the casing. An electronic component is mounted in the interior of the casing. A cooling fan is mounted in the interior of the casing. The cooling fan is adapted to guide air currents via the at least one vent to cool the electronic component.

In an example (embodiment) the at least one vent is defined in the first face of the casing and adjoins the junction section.

In another example, the at least one vent is defined in the annular periphery of the first cover and adjoins the junction section.

In a further example, the at least one vent includes a first opening defined in the first face of the casing and a second opening defined in the first cover, with the first and second openings together forming the at least one vent.

In still another example, the at least one vent includes a plurality of vents distributed along two sides of the first cover. The two sides of the first cover are opposite to or adjacent to each other.

In yet another example, the at least one vent is a continuous elongated slot.

In still another example, the at least one vent is provided at at least one corner of the first cover.

In yet another example, the annular periphery of the first cover intersects the first face of the casing by only one side, and the side of the annular periphery of the first cover includes the junction section.

Preferably, a display is mounted to the first face of the casing, and the first cover abuts the first face of the casing and covers the display.

In still another example, a second cover abuts the second face of the casing. The second cover covers a portion of the second face of the casing. A junction section between the second face of the casing and the second cover includes at least one auxiliary vent. The at least one auxiliary vent is defined in the second face of the casing and adjoins the junction section between the second face of the casing and the second cover. In an example, the at least one auxiliary vent includes a plurality of auxiliary vents distributed along two sides of the second cover. The two sides of the second cover are opposite to or adjacent to each other. In an alternative example, the at least one auxiliary vent is a continuous elongated slot.

The present invention will become clearer in light of the following detailed description of illustrative embodiments of this invention described in connection with the drawings.

### BRIEF DESCRIPTION OF THE DRAWINGS

The illustrative embodiments may best be described by reference to the accompanying drawings where:
FIG. 1 is a perspective view of a conventional hand-held electronic device.
FIG. 2 is a schematic view of a conventional cell phone.
FIG. 3 is a perspective view of a hand-held electronic device of a first embodiment according to the present invention.
FIG. 4 is a cross sectional view taken along section line 4-4 of FIG. 3.
FIG. 5 is a perspective view of another example of the hand-held electronic device of the first embodiment according to the present invention, with the hand-held electronic device including two elongated vents.
FIG. 6 is a perspective view of a further example of the hand-held electronic device of the first embodiment according to the present invention, with a vent provided at each of four corners of a first cover of the hand-held electronic device.
FIG. 7 is a perspective view of still another example of the hand-held electronic device of the first embodiment according to the present invention, with vents formed along a side of the first cover.
FIG. 8 is a cross sectional view of yet another example of the hand-held electronic device of the first embodiment according to the present invention, with the hand-held electronic device including a second cover and auxiliary vents.
FIG. 9 is a cross sectional view of still another example of the hand-held electronic device of the first embodiment according to the present invention, with the vents formed in the second cover only.
FIG. 10 is a perspective view of a hand-held electronic device of a second embodiment according to the present invention.
FIG. 11 is a cross sectional view taken along section line 11-11 of FIG. 10.
FIG. 12 is a perspective view of a hand-held electronic device of a third embodiment according to the present invention.
FIG. 13 is a cross sectional view taken along section line 13-13 of FIG. 12.

### DETAILED DESCRIPTION OF THE INVENTION

A hand-held electronic device according to the present invention can be a cell phone, a tablet computer, a hand-held game console, a music player, a digital video cassette camcorder, or a digital camera. The hand-held electronic device will be described by way of example of a cell phone without any limiting purposes.

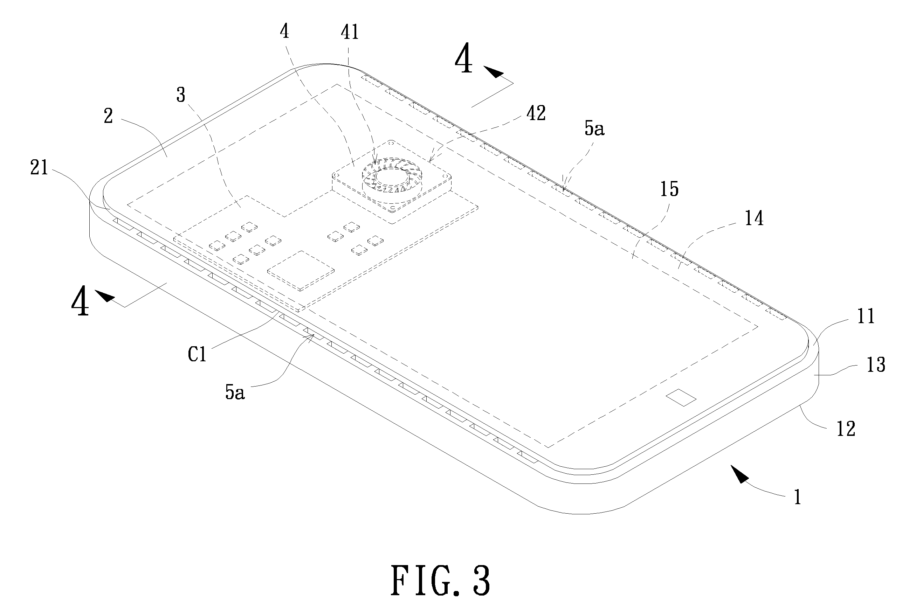

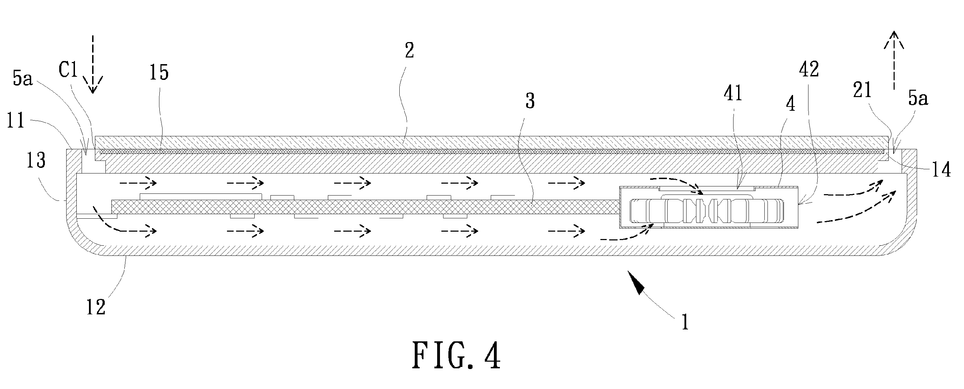

FIGS. 3 and 4 show a hand-held electronic device of a first embodiment according to the present invention. Specifically, the hand-held electronic device includes a casing 1, a first cover 2, an electronic component 3, and a cooling fan 4. The first cover 2 is mounted to an outer side of the casing 1. The electronic component 3 and the cooling fan 4 are mounted in an interior of the casing 1. When the cooling fan 4 operates, air currents are guided into and out of the casing 1 to reduce the operating temperature of the electronic component 3.

The casing 1 includes a first face 11 and a second face 12 opposite to the first face 11. The interior of the casing 1 is intermediate the first face 11 and the second face 12. A peripheral wall 13 is provided between the first face 11 and the second face 12. In the embodiment shown in FIG. 3, the first face 11 of the casing 1 faces a user when the hand-held electronic device is in use. The casing 1 further includes a frame 14 and a display 15. The frame 14 surrounds an outer periphery of the display 15 and is located adjacent to the first face 11 of the casing 1.

The first cover 2 can be made of a material such as reinforced glass. The first cover 2 abuts the first face 11 of the casing 1 and covers the display 15 and a portion of the frame 14 to protect the display 15 from impact and wear. The first cover 2 includes a thickness forming an annular periphery 21. A joining area between the annular periphery 21 of the first cover 2 and the first face 11 of the casing 1 includes a junction section C1 having at least one vent 5a in communication with the interior and an exterior of the casing 1. In this embodiment, the at least one vent 5a is formed in the first face 11 of the casing 1 and is located adjacent to the junction section C1 to allow easy manufacture. Preferably, the at least one vent 5a includes a plurality of vents 5a distributed along two sides of the first cover 2, with the two sides of the first cover 2 opposite to or adjacent to each other. For example, the vents 5a can be located on left and right sides or upper and lower sides of the first cover 2. Alternatively, the vents 5a can be located on the upper and right sides or the upper, left and right sides of the first cover 2 to provide a better air guiding effect. Even if some of the vents 5a are covered, the cooling fan 4 can guide air currents into the casing 1 via the vents 5a that are not covered.

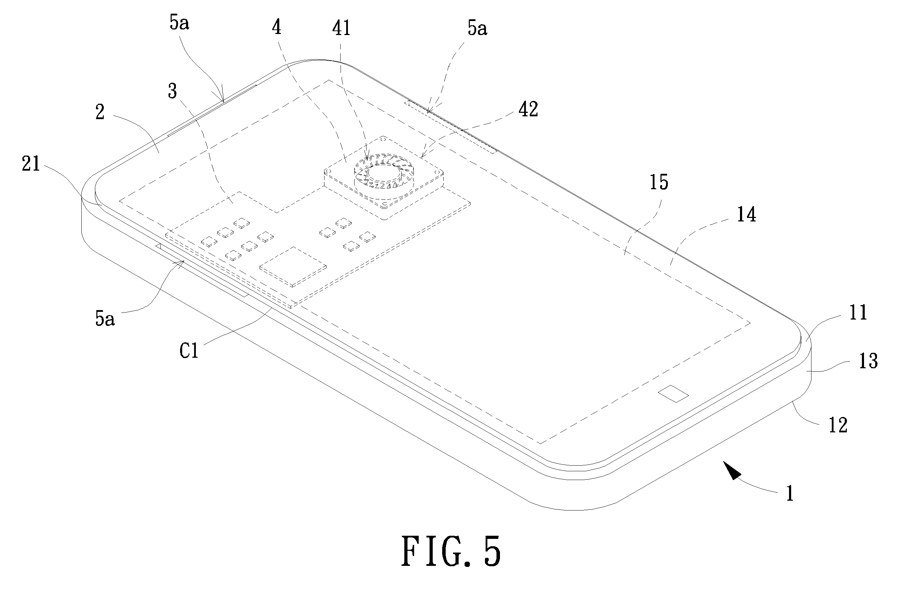

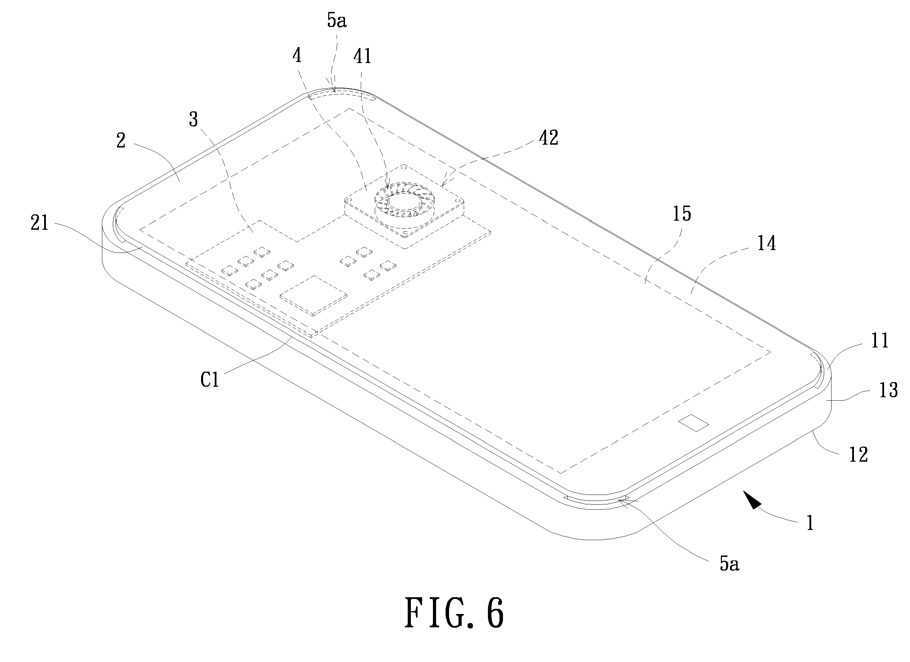

Alternatively, as shown in FIG. 5, at least one of the vents 5a can be in the form of a continuous elongated slot. Thus, the intercommunicating area between the interior and the exterior of the casing 1 can be increased to further increase the heat dissipating effect while allowing easy manufacture. Preferably, plural vents 5a are provided on two opposite sides or two adjacent sides of the first cover 2. In another example, the at least one vent 5a is provided at at least one corner of the first cover 2. In the example shown in FIG. 6, a vent 5a is provided at each corner of the first cover 2. Thus, the vents 5a are located in positions less likely to be blocked by the hand of the user to maintain excellent cooling efficiency of the hand-held electronic device.

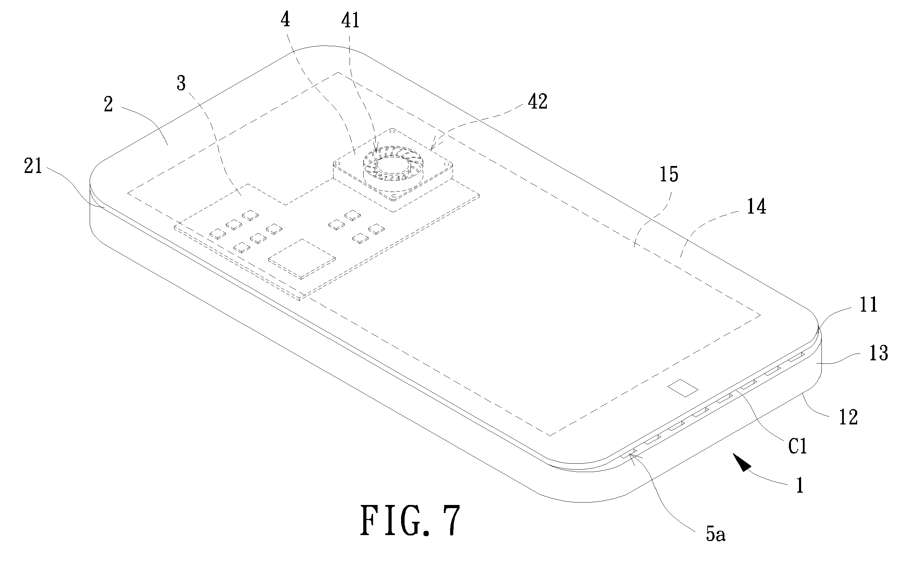

In a further example shown in FIG. 7, the annular periphery 21 of the first cover 2 intersects the first face 11 of the casing 1 by only one side, and this side of the annular periphery 21 of the first cover 2 includes the junction section C1. Furthermore, all of the vents 5a are located on the junction section C1. Thus, the area of the frame 14 covered by the first cover 2 is not limited to the illustrated examples.

The electronic component 3 and the cooling fan 4 are both mounted in the interior of the casing 1. The electronic component 3 can be a processor of a cell phone. The cooling fan 4 is adapted to guide air currents via the at least one vent 5a to cool the electronic component 3. Preferably, the cooling fan 4 is located adjacent to the electronic component 3 to increase the cooling efficiency of the electronic component 3.

In this embodiment, the cooling fan 4 is a centrifugal fan and preferably a double inlet type centrifugal fan. The cooling fan 4 includes an air inlet 41 in an axial direction and an air outlet 42 in a radial direction. The air outlet 42 is located adjacent to the vents 5a on a side of the first cover 2. When the cooling fan 4 operates, the air in the interior of the casing 1 is guided by the cooling fan 4 to pass through the vents 5a adjacent to the air outlet 42 to the outside, forming a negative pressure in the interior of the casing 1. Thus, air outside the casing 1 is guided into the interior of the casing 1 via the vents 5a on the other side of the first cover 2. Accordingly, the low-temperature air outside the casing 1 can flow into the casing 1 and pass through the electronic component 3 to carry away the heat generated during operation of the electronic component 3. As a result, the high-temperature air in the interior of the casing 1 can be expelled by the cooling fan 4 to lower the operational temperature of the electronic component 3, maintaining normal operation.

By the above structural features, the at least one vent 5a can be located in the junction section C 1 between the first face 11 of the casing 1 and the first cover 2 and is, thus, located in a stepped portion less likely to be blocked by the hand of the user. Thus, when the user is using the hand-held electronic device, the at least one vent 5a can maintain communication between the interior and exterior of the casing 1, allowing the cooling fan 4 to smoothly guide air currents into and out of the casing 1 and providing the electronic component 3 with a continuous cooling effect. Furthermore, in the embodiment shown in FIG. 3, the vents 5a are defined in the first face 11 of the casing 1 facing the user such that the vents 5a always face the user without obstruction by the hand of the user using the hand-held electronic device, further increasing the cooling effect of the electronic component 3 by the cooling fan 4.

Based on the above technical concept of the hand-held electronic device according to the present invention, other structural features can be included to provide more functions.

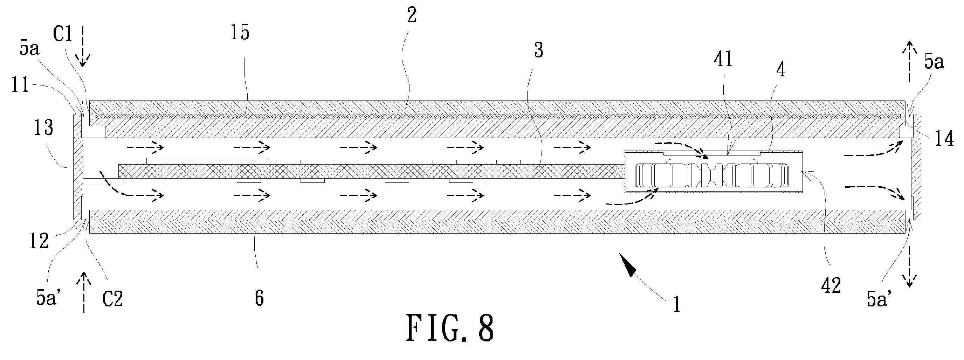

With reference to FIG. 8, a second cover 6 is provided and abuts the second face 12 of the casing 1 to increase the structural strength of the hand-held electronic device for protecting the electronic component 3 in the casing 1. Furthermore, the first face 11 and the second face 12 of the casing 1 can be a plane. The peripheral wall 13 is connected to peripheral edges of the first face 11 and the second face 12 to form the casing 1 in the form of a box-like parallelepiped. The second cover 6 can only cover a portion of the second face 12 of the casing 1 to form a symmetric arrangement to the first cover 2 abutting the first face 11 of the casing 1, forming a stepped portion between the second cover 6 and the second face 12 of the casing 1. Thus, a junction section C2 between the second face 12 of the casing 1 and the second cover 6 can include at least one auxiliary vent 5a'. To allow easy manufacture, the at least one auxiliary vent 5a' is defined in the second face 12 of the casing 1 and adjoins the junction section C2 between the second face 12 of the casing 1 and the second cover 6. Preferably, plural auxiliary vents 5a' are provided and distributed along two sides of the second cover 6, with the two sides of the second cover 6 opposite to or adjacent to each other, providing enhanced air guiding effect. Alternatively, the at least one auxiliary vent 5a' can be a continuous elongated slot to increase the cooling efficiency while allowing easy manufacture.

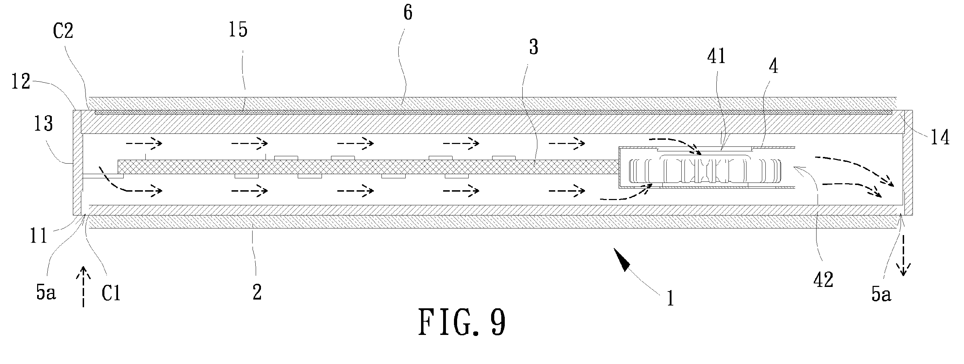

With reference to FIG. 9, in still another example of the first embodiment according to the present invention, the first face 11 of the casing 1 faces away from the user using the hand-held electronic device, and the second face 12 of the casing 1 faces the user. Namely, the frame 14 and the display 15 are located adjacent to the second face 12 of the casing 1. Furthermore, the first cover 2 abuts the first face 11, and a junction section C1 is provided at the joining area between the first cover 2 and the first face 11. The second cover 6 abuts the second face 12, and another junction section C2 is provided between the joining area between the second cover 6 and the second face 12.

In the example shown in FIG. 9, the junction section C2 between the second face 12 of the casing 1 and the second cover 6 can be closed and free of holes. Furthermore, the vents 5a are provided on the first face 11 of the casing 1 and adjoin the junction section C1 between the first face 11 and the first cover 2. By such an arrangement, when the hand-held electronic device is in use, the cooling fan 4 guides the high-temperature air to exit the rear side of the hand-held electronic device instead of sending the high-temperature air to the user, increasing the use comfort of the hand-held electronic device.

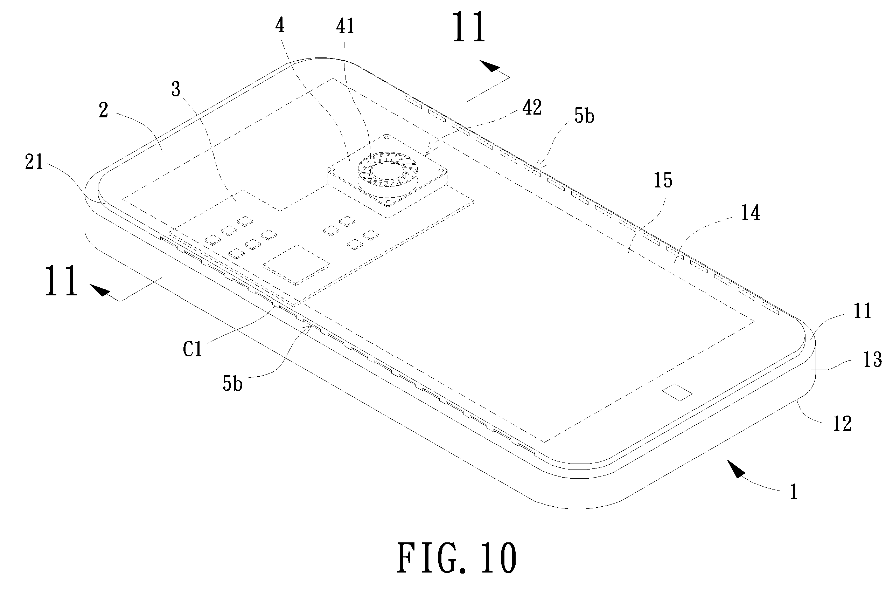

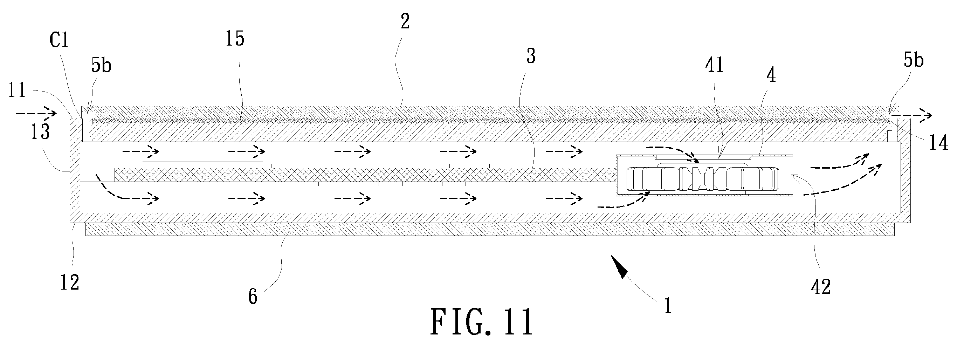

FIGS. 10 and 11 illustrate a second embodiment of the present invention substantially the same as the first embodiment except that the at least one vent 5b is defined in the annular periphery 21 of the first cover 2 and adjoins the junction section C 1. Thus, the at least one vent 5b is located in a position farther to the peripheral wall 13 of the casing 1, further avoiding the at least one vent 5b from being covered. Furthermore, the at least one vent 5b in the annular periphery 21 of the first cover 2 makes the opening of the at least one vent 5b face two lateral sides of the hand-held electronic device. Thus, the hot air is guided by the cooling fan 4 and is discharged via the lateral sides of the hand-held electronic device, rather than discharged toward the user.

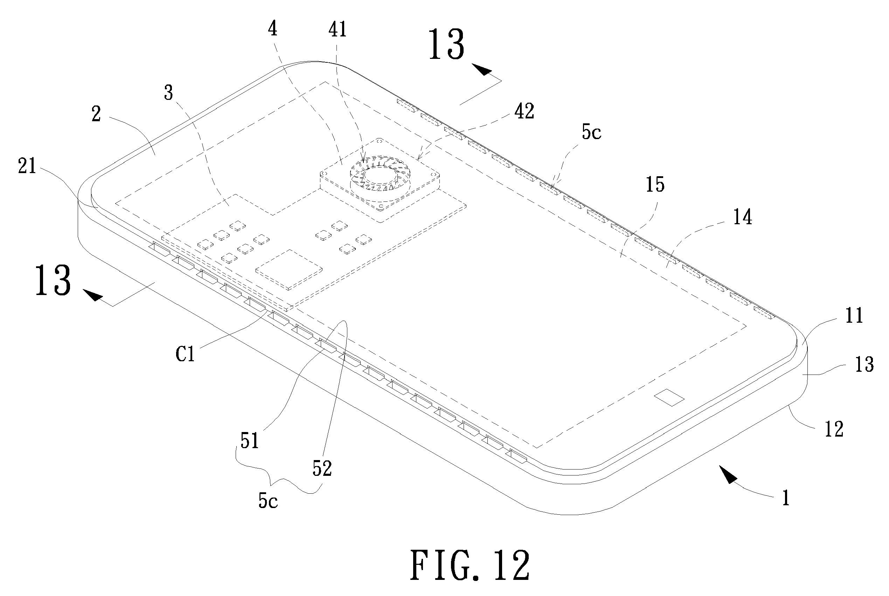

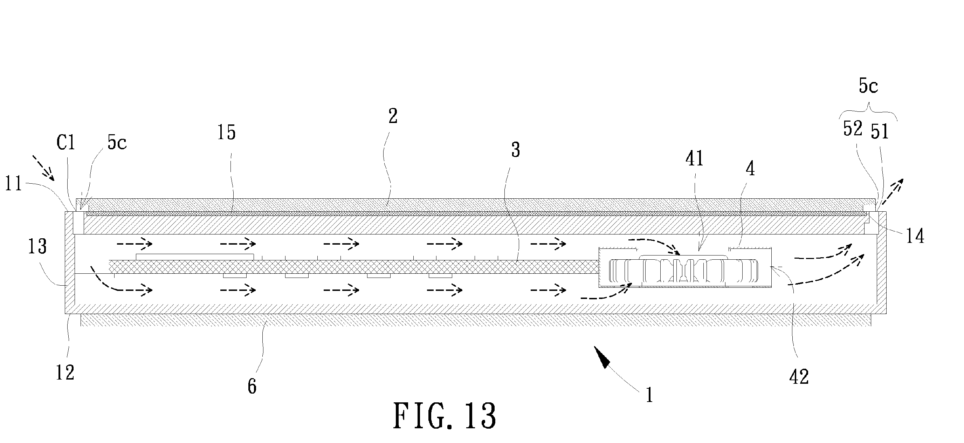

FIGS. 12 and 13 illustrate a third embodiment of the present invention substantially the same as the second embodiment except that the at least one vent 5c includes a first opening 51 defined in the first face 11 of the casing 1 and a second opening 52 defined in the first cover 2, with the first and second openings 51, 52 together forming the at least one vent 5c. Compared to the first and second embodiments, the at least one vent 5c of the third embodiment reduce the holed areas in the casing 1 and the first cover 2, increasing the structural strengths of the casing 1 and the first cover 2. The first opening 51 and the second opening 52 can be completely or partially aligned with each other.

In view of the foregoing, by providing the at least one vent 5a, 5a', 5b, 5c in the junction section C1, C2 between the first cover 2 and/or the second cover 6 and the first face 11 and/or the second face 12 of the casing 1, the at least one vent 5a, 5a', 5b, 5c is located in a stepped portion of the hand-held electronic device according to the present invention and is, thus, less likely to be blocked by the hand of the user. Thus, the at least one vent 5a, 5a', 5b, 5c can intercommunicate the interior of the casing 1 with the outside, allowing the cooling fan 4 to smoothly guide air currents into and out of the casing 1, achieving the expected cooling effect.

Thus since the invention disclosed herein may be embodied in other specific forms without departing from the general characteristics thereof, some of which forms have been indicated, the embodiments described herein are to be considered in all respects illustrative and not restrictive. The scope of the invention is to be indicated by the appended claims, rather than by the foregoing description, and all changes which come within the meaning and range of the claims are intended to be embraced therein.

## Claims

1. A hand-held electronic device comprising:
a casing (1) including a first face (11) and a second face (12) opposite to the first face (11), with the casing (1) including an interior intermediate the first face (11) and the second face (12) of the casing (1);
an electronic component (3) mounted in the interior of the casing (1); and
a cooling fan (4) mounted in the interior of the casing (1),
wherein the hand-held electronic device is **characterized in** further comprising a first cover (2) including a thickness forming an annular periphery (21), with the first cover (2) abutting the first face (11) of the casing (1), with a joining area between the annular periphery (21) of the first cover (2) and the first face (11) of the casing (1) including a junction section (C1), with the junction section (C1) having at least one vent (5a, 5b, 5c) in communication with the interior of the casing (1), and with the cooling fan (4) adapted to guide air currents via the at least one vent (5a, 5b, 5c) to cool the electronic component (3).

2. The hand-held electronic device as claimed in claim 1, **characterized in that** the at least one vent (5a) is defined in the first face (11) of the casing (1) and adjoins the junction section (C1).

3. The hand-held electronic device as claimed in claim 1, **characterized in that** the at least one vent (5b) is defined in the annular periphery (21) of the first cover (2) and adjoins the junction section (C1).

4. The hand-held electronic device as claimed in claim 1, **characterized in that** the at least one vent (5c) includes a first opening (51) defined in the first face (11) of the casing (1) and a second opening (52) defined in the first cover (2), with the first and second openings (51, 52) together forming the at least one vent (5c).

5. The hand-held electronic device as claimed in claim 1, **characterized in that** the at least one vent (5a) includes a plurality of vents (5a) distributed along two sides of the first cover (2), and with the two sides of the first cover (2) opposite to or adjacent to each other.

6. The hand-held electronic device as claimed in claim 1, **characterized in that** the at least one vent is (5a) a continuous elongated slot.

7. The hand-held electronic device as claimed in claim 1, **characterized in that** the at least one vent (5a) is provided at at least one comer of the first cover (2).

8. The hand-held electronic device as claimed in claim 1, **characterized in that** the annular periphery (21) of the first cover (2) intersects the first face (11) of the casing (1) by only one side, and with the side of the annular periphery (21) of the first cover (2) including the junction section (C1).

9. The hand-held electronic device as claimed in claim 1, **characterized in** further comprising: a display (15) mounted to the first face (11) of the casing (1), and with the first cover (2) abutting the first face (11) of the casing (1) and covering the display (15).

10. The hand-held electronic device as claimed in claim 1, **characterized in** further comprising: a second cover (6) abutting the second face (12) of the casing (1).

11. The hand-held electronic device as claimed in claim 10, **characterized in that** the second cover (6) covers a portion of the second face (12) of the casing (1), with the second face (12) of the casing (1) and the second cover (6) having a junction section (C1) therebetween, and with the junction section (C1) between the second face (12) of the casing (1) and the second cover (6) including at least one auxiliary vent (5a').

12. The hand-held electronic device as claimed in claim 11, **characterized in that** the at least one auxiliary vent (5a') is defined in the second face (12) of the casing (1) and adjoins the junction section (C1) between the second face (12) of the casing (1) and the second cover (6).

13. The hand-held electronic device as claimed in claim 11, **characterized in that** the at least one auxiliary vent (5a') includes a plurality of auxiliary vents (5a'), with the plurality of auxiliary vents (5a') distributed along two sides of the second cover (6), and with the two sides of the second cover (6) opposite to or adjacent to each other.

14. The hand-held electronic device as claimed in claim 11, **characterized in that** the at least one auxiliary vent (5a') is a continuous elongated slot.

## Patentansprüche

1. Tragbare elektronische Vorrichtung, die Folgendes umfasst:
ein Gehäuse (1), das eine erste Oberfläche (11) und eine zweite Oberfläche (12), die der ersten Oberfläche (11) gegenüberliegt, enthält, wobei das Gehäuse (1) einen Innenraum, der zwischen der ersten Oberfläche (11) und der zweiten Oberfläche (12) des Gehäuses liegt, enthält;
eine elektronische Komponente (3), die in dem Innenraum des Gehäuses (1) montiert ist; und
einen Kühlventilator (4), der in dem Innenraum des Gehäuses (1) montiert ist,
wobei die tragbare elektronische Vorrichtung **dadurch gekennzeichnet ist, dass** sie ferner eine erste Abdeckung (2) umfasst, die eine Verdickung besitzt, die einen ringförmigen Rand (21) bildet, wobei die erste Abdeckung (2) an die erste Oberfläche (11) des Gehäuses (1) angrenzt, wobei eine Fügefläche zwischen dem ringförmigen Rand (21) der ersten Abdeckung (2) und der ersten Oberfläche (11) des Gehäuses (1) einen Verbindungsabschnitt (C1) enthält, wobei der Verbindungsabschnitt (C1) mindestens eine Lüftungsöffnung (5a, 5b, 5c) aufweist, die sich in Kommunikation mit dem Innenraum des Gehäuses (1) befindet, und wobei der Kühlventilator (4) dafür ausgelegt ist, Luftströme über die mindestens eine Lüftungsöffnung (5a, 5b, 5c) zu leiten, um die elektronische Komponente (3) zu kühlen.

2. Tragbare elektronische Vorrichtung nach Anspruch 1, **dadurch gekennzeichnet, dass** die mindestens eine Lüftungsöffnung (5a) in der ersten Oberfläche (11) des Gehäuses (1) definiert ist und an den Verbindungsabschnitt (C1) angrenzt.

3. Tragbare elektronische Vorrichtung nach Anspruch 1, **dadurch gekennzeichnet, dass** die mindestens eine Lüftungsöffnung (5b) in dem ringförmigen Rand (21) der ersten Abdeckung (2) definiert ist und an den Verbindungsabschnitt (C1) angrenzt.

4. Tragbare elektronische Vorrichtung nach Anspruch 1, **dadurch gekennzeichnet, dass** die mindestens eine Lüftungsöffnung (5c) eine erste Öffnung (51), die in der ersten Oberfläche (11) des Gehäuses (1) definiert ist, und eine zweite Öffnung (52), die in der ersten Abdeckung (2) definiert ist, enthält, wobei die erste und die zweite Öffnung (51, 52) zusammen die mindestens eine Lüftungsöffnung (5c) bilden.

5. Tragbare elektronische Vorrichtung nach Anspruch 1, **dadurch gekennzeichnet, dass** die mindestens eine Lüftungsöffnung (5a) mehrere Lüftungsöffnungen (5a) enthält, die entlang zwei Seiten der ersten Abdeckung (2) verteilt sind, und wobei die zwei Seiten der ersten Abdeckung (2) gegenüber voneinander oder nebeneinander liegen.

6. Tragbare elektronische Vorrichtung nach Anspruch 1, **dadurch gekennzeichnet, dass** die mindestens eine Lüftungsöffnung (5a) ein durchgehender Langschlitz ist.

7. Tragbare elektronische Vorrichtung nach Anspruch 1, **dadurch gekennzeichnet, dass** die mindestens eine Lüftungsöffnung (5a) an mindestens einer Ecke der ersten Abdeckung (2) vorgesehen ist.

8. Tragbare elektronische Vorrichtung nach Anspruch 1, **dadurch gekennzeichnet, dass** der ringförmige Rand (21) der ersten Abdeckung (2) die erste Oberfläche (11) des Gehäuses (1) nur an einer Seite kreuzt, und wobei die Seite des ringförmigen Randes (21) der ersten Abdeckung (2) den Verbindungsabschnitt (C1) enthält.

9. Tragbare elektronische Vorrichtung nach Anspruch 1, **dadurch gekennzeichnet, dass** sie ferner Folgendes umfasst: eine Anzeigevorrichtung (15), die an die erste Oberfläche (11) des Gehäuses (1) montiert ist, und wobei die erste Abdeckung (2) an die erste Oberfläche (11) des Gehäuses (1) angrenzt und die Anzeigevorrichtung (15) bedeckt.

10. Tragbare elektronische Vorrichtung nach Anspruch 1, **dadurch gekennzeichnet, dass** sie ferner Folgendes umfasst: eine zweite Abdeckung (6), die an die zweite Oberfläche (12) des Gehäuses (1) angrenzt.

11. Tragbare elektronische Vorrichtung nach Anspruch 10, **dadurch gekennzeichnet, dass** die zweite Abdeckung (6) einen Abschnitt der zweiten Oberfläche (12) des Gehäuses (1) bedeckt, wobei die zweite Oberfläche (12) des Gehäuses (1) und die zweite Abdeckung (6) einen Verbindungsabschnitt (C1) zwischen sich haben, und wobei der Verbindungsabschnitt (C1) zwischen der zweiten Oberfläche (12) des Gehäuses (1) und der zweiten Abdeckung (6) mindestens eine Hilfslüftungsöffnung (5a') enthält.

12. Tragbare elektronische Vorrichtung nach Anspruch 11, **dadurch gekennzeichnet, dass** die mindestens eine Hilfslüftungsöffnung (5a') in der zweiten Oberfläche (12) des Gehäuses (1) definiert ist und an den Verbindungsabschnitt (C1) zwischen der zweiten Oberfläche (12) des Gehäuses (1) und der zweiten Abdeckung (6) angrenzt.

13. Tragbare elektronische Vorrichtung nach Anspruch 11, **dadurch gekennzeichnet, dass** die mindestens eine Hilfslüftungsöffnung (5a') mehrere Hilfslüftungsöffnungen (5a') enthält, wobei die Hilfslüftungsöffnungen (5a') entlang zwei Seiten der zweiten Abdeckung (6) verteilt sind, und wobei die zwei Seiten der zweiten Abdeckung (6) gegenüber voneinander oder nebeneinander liegen.

14. Tragbare elektronische Vorrichtung nach Anspruch 11, **dadurch gekennzeichnet, dass** die mindestens eine Hilfslüftungsöffnung (5a') ein durchgehender Langschlitz ist.

## Revendications

1. Dispositif électronique portatif qui comprend :
un boîtier (1) qui comprend une première face (11) et une seconde face (12) opposée à la première face (11), le boîtier (1) comprenant un intérieur situé entre la première face (11) et la seconde face (12) du boîtier (1) ;
un composant électronique (3) monté à l'intérieur du boîtier (1) ; et
un ventilateur de refroidissement (4) monté à l'intérieur du boîtier (1),
le dispositif électronique portatif étant **caractérisé en ce qu'**il comprend en outre un premier capot (2) qui comprend une épaisseur qui forme une périphérie annulaire (21), le premier capot (2) butant contre la première face (11) du boîtier (1), avec une zone de jonction entre la périphérie annulaire (21) du premier capot (2) et la première face (11) du boîtier (1) qui comprend une section de jonction (C1), la section de jonction (C1) ayant au moins une aération (5a, 5b, 5c) en communication avec l'intérieur du boîtier (1), et le ventilateur de refroidissement (4) étant adapté pour guider des courants d'air par le biais de ladite aération (5a, 5b, 5c) afin de refroidir le composant électronique (3).

2. Dispositif électronique portatif selon la revendication 1, **caractérisé en ce que** ladite aération (5a) est définie dans la première face (11) du boîtier (1) et est contigüe à la section de jonction (C1).

3. Dispositif électronique portatif selon la revendication 1, **caractérisé en ce que** ladite aération (5b) est définie dans la périphérie annulaire (21) du premier capot (2) et est contigüe à la section de jonction (C1).

4. Dispositif électronique portatif selon la revendication 1, **caractérisé en ce que** ladite aération (5c) comprend une première ouverture (51) définie dans la première face (11) du boîtier (1) et une seconde ouverture (52) définie dans le premier capot (2), la première et la seconde ouvertures (51, 52) formant ensemble ladite aération (5c).

5. Dispositif électronique portatif selon la revendication 1, **caractérisé en ce que** ladite aération (5a) comprend une pluralité d'aérations (5a) réparties le long de deux côtés du premier capot (2), les deux côtés du premier capot (2) étant opposés ou adjacents l'un à l'autre.

6. Dispositif électronique portatif selon la revendication 1, **caractérisé en ce que** ladite aération (5a) est une fente allongée continue.

7. Dispositif électronique portatif selon la revendication 1, **caractérisé en ce que** ladite aération (5a) est prévue au moins au niveau d'un angle du premier capot (2).

8. Dispositif électronique portatif selon la revendication 1, **caractérisé en ce que** la périphérie annulaire (21) du premier capot (2) croise la première face (11) du boîtier (1) d'un seul côté, le côté de la périphérie annulaire (21) du premier capot (2) comprenant la section de jonction (C1).

9. Dispositif électronique portatif selon la revendication 1, **caractérisé en ce qu'**il comprend en outre : un écran (15) monté sur la première face (11) du boîtier (1), le premier capot (2) butant contre la première face (11) du boîtier (1) et recouvrant l'écran (15).

10. Dispositif électronique portatif selon la revendication 1, **caractérisé en ce qu'**il comprend en outre : un second capot (6) qui bute contre la seconde face (12) du boîtier (1).

11. Dispositif électronique portatif selon la revendication 10, **caractérisé en ce que** le second capot (6) recouvre une partie de la seconde face (12) du boîtier (1), la seconde face (12) du boîtier (1) et le second capot (6) ayant une section de jonction (C1) entre eux, et la section de jonction (C1) située entre la seconde face (12) du boîtier (1) et le second capot (6) comprenant au moins une aération auxiliaire (5a').

12. Dispositif électronique portatif selon la revendication 11, **caractérisé en ce que** ladite aération auxiliaire (5a') est définie dans la seconde face (12) du boîtier (1) et est contigüe à la section de jonction (C1) entre la seconde face (12) du boîtier (1) et le second capot (6).

13. Dispositif électronique portatif selon la revendication 11, **caractérisé en ce que** ladite aération auxiliaire (5a') comprend une pluralité d'aérations auxiliaires (5a'), les aérations auxiliaires (5a') étant réparties le long de deux côtés du second capot (6), les deux côtés du second capot (6) étant opposés ou adjacents l'un à l'autre.

14. Dispositif électronique portatif selon la revendication 11, **caractérisé en ce que** ladite aération auxiliaire (5a') est une fente allongée continue.
